# EUROPÄISCHE PATENTSCHRIFT

(11) **EP 3 487 720 B1**
(45) Veröffentlichungstag und Bekanntmachung des Hinweises auf die Patenterteilung: **05.05.2021**
(21) Anmeldenummer: 17723675.9
(22) Anmeldetag: 12.05.2017
(51) Int. Cl.: B60J 1/00, H03K 17/96, B32B 17/10

(54) **FENSTERSCHEIBE MIT KAPAZITIVEM SCHALTBEREICH ZUR BERÜHRUNGSLOSEN STEUERUNG EINER FUNKTION**
WINDOW PANE WITH CAPACITIVE RANGE FOR TOUCH-FREE CONTROL OF A FUNCTION
VITRE DE FENETRE A ZONE DE COMMUTATION CAPACITIVE DESTINEE A LA COMMANDE SANS CONTACT D'UNE FONCTION

(30) Priorität: 20.07.2016 EP 16180280
(43) Veröffentlichungstag der Anmeldung: 29.05.2019
(73) Patentinhaber: SAINT-GOBAIN GLASS FRANCE, 92400 Courbevoie (FR)
(72) Erfinder: WEBER, Patrick, 52477 Alsdorf (DE)
(74) Vertreter: Gebauer, Dieter Edmund
(86) Internationale Anmeldenummer: PCT/EP2017/061430
(87) Internationale Veröffentlichungsnummer: WO 2018/015040

(56) Entgegenhaltungen:
- EP-A2- 1 477 351
- WO-A1-2008/113978
- WO-A1-2015/162107
- WO-A1-2015/162108

## Beschreibung

Die Erfindung betrifft eine Fensterscheibe mit Beschichtung und kapazitivem Schaltbereich, eine Fensterscheibenanordnung, ein Verfahren zur Herstellung der Fensterscheibe und deren Verwendung.

Ein Innenraum eines Kraftfahrzeugs ist heutzutage üblicherweise mit einem Panoramadach als Dach ausgebildet. Ein Panaromadach weist eine Verbundstruktur auf, die eine transparente Fahrzeugscheibe umfasst. Im Sommer kann sich bei intensiver direkter Sonneneinstrahlung das Fahrzeug stark erwärmen. Im Winter bei niedriger Außentemperatur wirkt die Fahrzeugscheibe als eine Wärmesenke und der Fahrzeuginnenraum kann unangenehm auskühlen. Zur Kühlung im Sommer und zum Heizen im Winter muss eine Klimaanlage des Fahrzeugs eine hohe Heizleistung erzeugen, um eine Erhitzung bzw. Auskühlung des Innenraums über die Fahrzeugscheiben zu vermeiden.

Zur Vermeidung einer übermäßigen Aufwärmung des Innenraums sind Fahrzeugscheiben mit einer Wärmestrahlung reflektierenden Beschichtung ausgestattet. Diese sogenannten Low-E-Beschichtungen sind beispielsweise aus WO 2013/131667 A1 bekannt. Eine solche Low-E-Beschichtung reflektiert einen erheblichen Teil der Sonnenstrahlung, insbesondere im Infrarotbereich, was im Sommer zu einer verringerten Erwärmung des Fahrzeuginnenraums führt.

Des Weiteren ist bekannt, dass eine beschichtete Fensterscheibe zusätzlich einen Schaltbereich zur Steuerung einer Funktion, z.B. Heizfunktion, aufweisen kann, siehe z.B. WO2015/162107 A1.

Derartige Schaltbereiche können durch eine Flächenelektrode oder durch eine Anordnung von zwei gekoppelten Elektroden ausgebildet sein, beispielsweise als kapazitive Schaltbereiche. Nähert sich ein Objekt dem Schaltbereich an, so ändert sich die Kapazität der Flächenelektrode gegen Erde oder die Kapazität des von den zwei gekoppelten Elektroden gebildeten Kondensators. Die Kapazitätsänderung wird über eine Schaltungsanordnung oder Sensorelektronik gemessen und bei Überschreiten eines Schwellwerts wird ein Schaltsignal ausgelöst. Schaltungsanordnungen für kapazitive Schalter sind beispielsweise aus EP 0 899 882 A1 bekannt. Nach dem Stand der Technik wird ein Schaltsignal dadurch ausgelöst, dass eine Berührungsfläche des kapazitiven Schaltbereichs durch eine menschliche Hand berührt wird. Die Berührung der Fahrzeugscheibe hinterlässt eine Verschmutzung in Form von Finderabdrücken und anderen Partikeln, die die Funktionsweis des Schaltbereichs beeinträchtigen können.

EP 1477351 A2 zeigt eine Sensoranordnung für eine Wischsteuerung, die sich in einer Mulde befindet.

Die Aufgabe der vorliegenden Erfindung besteht darin, eine verbesserte Fensterscheibe bereitzustellen, die einen kapazitiven Schaltbereich aufweist, bei dessen Betätigung die Fensterscheibe nicht verschmutzt wird.

Die Aufgabe der vorliegenden Erfindung wird erfindungsgemäß durch eine Fensterscheibe mit mehreren kapazitiven Schaltbereichen gemäß dem unabhängigen Anspruch 1 gelöst. Bevorzugte Ausführungen gehen aus den Unteransprüchen hervor.

Die erfindungsgemäße Fensterscheibe mit mehreren kapazitiven Schaltbereichen, zur Abtrennung eines Innenraums von einer äußeren Umgebung, umfasst eine Scheibe mit einer innenseitigen Oberfläche und einer Beschichtung, die zumindest teilweise auf der innenseitigen Oberfläche der Scheibe angeordnet ist, wobei jeweils ein kapazitiver Schaltbereich durch mindestens eine beschichtungsfreie Trennlinie aus der Beschichtung elektrisch abgetrennt ist, und mit einer Sensorelektronik elektrisch verbindbar ist sowie einen Erfassungsbereich zum berührungslosen Erfassen von einem von einer Person in einem Aktivierungsbereich bewegten Gegenstand und dessen Bewegungsrichtung aufweist.

Ein berührungsloses Erfassen von einer Person, vorzugsweise ihrer Hand oder einem Gegenstand mit ähnlichem Permittivitätsverhalten liegt im Sinne der Erfindung vor, wenn die Person, ihre Hand oder der Gegenstand ohne physikalischen Kontakt zu der Fensterscheibe von dem Erfassungsbereich erfasst wird. Mit anderen Worten, wenn der kapazitive Schaltbereich ein elektrisches Signal generiert, also ein elektrischer Ladungstransport vom Schaltbereich zur Sensorelektronik stattfindet, ohne dass die Fensterscheibe durch die Person, ihrer Hand oder dem Gegenstand berührt wurde.

Ein derartiger kapazitiver Schaltbereich ermöglicht die Steuerung einer Funktion in Abhängigkeit der Nähe der Person, ihrer Hand oder des Gegenstands. Durch das berührungslose Erfassen von einem bewegten Gegenstand gelangen keine Verschmutzungen von dem Gegenstand auf die Fensterscheibe und die Funktion des kapazitiven Schaltbereichs wird nicht beeinträchtig.

Die Fensterscheibe kann vielfältig eingesetzt werden: Im Falle einer Fensterscheibe als Fahrzeugscheibe, kann sie beispielsweise eine Dachscheibe, eine Windschutzscheibe, eine Heckscheibe, eine Seitenscheibe oder eine andere den Fahrzeuginnenraum begrenzende Verglasung sein. Außenseitige Oberfläche der Scheibe bedeutet hierbei die Oberfläche der Scheibe, die nach außen, also von dem Fahrzeuginnenraum weg weißt. Innenseitige Oberfläche bedeutet demnach die Oberfläche der Scheibe, die zum Fahrzeuginnenraum hin weist.

Im Falle einer Fensterscheibe als Architekturscheibe oder als Bauverglasung, kann die Fensterscheibe beispielsweise eine Fassadenverglasung, eine Dachscheibe oder eine andere einen Wohnraum oder Gebäudeinnenraum begrenzende Verglasung sein. Außenseitige Oberfläche der Scheibe bedeutet hierbei die Oberfläche der Scheibe, die nach außen, also von dem Innenraum weg weißt. Innenseitige Oberfläche bedeutet demnach die Oberfläche der Scheibe, die zum Innenraum hin weist.

Die innenseitige Oberfläche weist eine sogenannte Low-E-Beschichtung als Beschichtung auf. Die außenseitige Oberfläche ist dann die zur innenseitigen Oberfläche gegenüberliegende Oberfläche der Scheibe.

Die sogenannte Low-E-Beschichtung enthält mindestens eine funktionelle Schicht und optional jeweils eine oder mehrere Haftschichten, Barriereschichten und/oder Antireflexionsschichten. Die Low-E-Beschichtung ist bevorzugt ein Schichtsystem aus jeweils mindestens einer Haftschicht, einer funktionellen Schicht, einer Barriereschicht, einer Antireflexionsschicht und einer weiteren Barriereschicht. Besonders geeignete Low-E-Beschichtungen enthalten eine funktionelle Schicht aus mindestens einem elektrisch leitfähigen Oxid (TCO), bevorzugt Indium-Zinnoxid (ITO), fluordotiertes Zinnoxid (SnO₂:F), antimon-dotiertes Zinnoxid (SnO₂:Sb), aluminiumdotiertes Zinkoxid (ZnO:Al) und/oder galliumdortiertes Zinkoxid (ZnO:Ga).

Besonders vorteilhafte erfindungsgemäße Low-E-Beschichtungen haben eine innenraumseitige Emissivität der erfindungsgemäßen Fensterscheibe von kleiner oder gleich 60%, bevorzugt kleiner oder gleich 45%, besonders bevorzugt kleiner oder gleich 30% und insbesondere kleiner oder gleich 20%. Mit innenraumseitiger Emissivität wird dabei das Maß bezeichnet, welches angibt, wie viel Wärmestrahlung die Scheibe in Einbaulage im Vergleich zu einem idealen Wärmestrahler (einem schwarzen Körper) in einen Innenraum, beispielsweise eines Gebäudes oder eines Fahrzeugs abgibt. Unter Emissivität wird im Sinne der Erfindung der normale Gesamtemissionsgrad bei 283 K nach der Norm EN 12898 verstanden.

Ein Flächenwiderstand der Low-E-Beschichtung kann von 10 Ohm/Quadrat bis 200 Ohm/Quadrat und bevorzugt von 10 Ohm/Quadrat bis 100 Ohm/Quadrat, besonders bevorzugt von 15 Ohm/Quadrat bis 50 Ohm/Quadrat und insbesondere von 20 Ohm/Quadrat bis 35 Ohm/Quadrat betragen.

Die Absorption der erfindungsgemäßen Low-E-Beschichtung im sichtbaren Spektralbereich beträgt bevorzugt von etwa 1% bis etwa 15 %, besonders bevorzugt von etwa 1 % bis etwa 7%. Die Absorption der Beschichtung kann dabei bestimmt werden, indem die Absorption einer beschichteten Scheibe gemessen wird und die Absorption der unbeschichteten Scheibe subtrahiert wird. Die erfindungsgemäße Fensterscheibe weist bei Reflexion bevorzugt einen Farbwert a* von -15 bis +5 und einen Farbwert b* von -15 bis +5 auf, betrachtet von der mit der Low-E-Beschichtung versehenen Seite aus. Die Angaben a* und b* beziehen sich auf die Farbkoordinaten gemäß dem kolorimetrischen Modell (L*a*b*-Farbraum).

Weiterhin kann die Low-E-Beschichtung im sichtbaren Spektralbereich eine geringe Absorption und eine geringe Reflexion und daher eine hohe Transmission aufweisen. Die Low-E-Beschichtung kann daher auch auf Scheiben verwendet werden, bei denen eine deutliche Verringerung der Transmission nicht gewünscht, beispielsweise bei Fensterscheiben in Gebäuden, oder gesetzlich verboten ist, beispielsweise bei Windschutzscheiben oder vorderen Seitenscheiben in Kraftfahrzeugen.

Die Low-E-Beschichtung hat den Vorteil korrosionsbeständig zu sein. Die Low-E-Beschichtung kann daher auf der Oberfläche der Scheibe aufgebracht sein, die dafür vorgesehen ist, in Einbaulage der Scheibe einem Innenraum, beispielsweise eines Fahrzeugs oder eines Gebäudes, zugewandt zu sein. Auf dieser Oberfläche verringert die Low-E-Beschichtung besonders effektiv im Sommer die Aussendung von Wärmestrahlung der Scheibe in den Innenraum und im Winter die Abstrahlung von Wärme in die äußere Umgebung.

Derartige Low-E-Beschichtungen sind besonders dazu geeignet, bei Dachverglasungen dem Fahrzeughalter so viel thermischen Komfort zu bieten, dass auf die Verwendung und mechanischen Sonnenschutz-Rollos verzichtet werden kann. Die funktionelle Schicht weist reflektierende Eigenschaften gegenüber Wärmestrahlung, insbesondere Infrarotstrahlung auf, ist im sichtbaren Spektralbereich jedoch weitgehend transparent. Die funktionelle Schicht enthält erfindungsgemäß zumindest ein transparentes, elektrisch leitfähiges Oxid (TCO). Der Brechungsindex des Materials der funktionellen Schicht beträgt bevorzugt von 1,7 bis 2,5. Die funktionelle Schicht enthält bevorzugt zumindest Indium-Zinn-Oxid (ITO). Damit werden besonders gute Ergebnisse hinsichtlich der Emissivität und der Biegbarkeit der erfindungsgemäßen Beschichtung erreicht.

Das Indium-Zinn-Oxid wird bevorzugt mittels magnetfeldunterstützter Kathodenzerstäubung mit einem Target aus Indium-Zinn-Oxid abgeschieden. Das Target enthält bevorzugt von 75 Gew. % bis 95 Gew. % Indiumoxid und von 5 Gew. % bis 25 Gew. % Zinnoxid sowie herstellungsbedingte Beimengungen. Die Abscheidung des Indium-Zinn-Oxids erfolgt bevorzugt unter einer Schutzgasatmosphäre, beispielsweise Argon. Dem Schutzgas kann auch ein geringer Anteil an Sauerstoff zugesetzt werden, beispielsweise um die Homogenität der funktionellen Schicht zu verbessern.

Das Target kann alternativ bevorzugt zumindest von 75 Gew. % bis 95 Gew. % Indium und von 5 Gew. % bis 25 Gew. % Zinn enthalten. Die Abscheidung des Indium-Zinn-Oxids erfolgt dann bevorzugt unter Zugabe von Sauerstoff als Reaktionsgas während der Kathodenzerstäubung.

Die Emissivität der erfindungsgemäßen Scheibe kann durch die Dicke der funktionellen Schicht beeinflusst werden. Die Dicke der funktionellen Schicht beträgt bevorzugt von 40 nm bis 200 nm, besonders bevorzugt von 90 nm bis 150 nm und ganz besonders bevorzugt von 100 nm bis 130 nm, beispielsweise etwa 120 nm. In diesem Bereich für die Dicke der funktionellen Schicht werden besonders vorteilhafte Werte für die Emissivität und eine besonders vorteilhafte Fähigkeit der funktionellen Schicht, eine mechanische Transformation wie Biegen oder Vorspannen ohne Beschädigung zu überstehen, erreicht.

Die funktionelle Schicht kann aber auch andere transparente, elektrisch leitfähige Oxide enthalten, beispielsweise Fluor-dotiertes Zinnoxid (SnO₂:F), Antimon-dotiertes Zinnoxid (SnO₂:Sb), Indium-Zink-Mischoxid (IZO), Gallium-dotiertes oder Aluminiumdotiertes Zinkoxid, Niobium-dotiertes Titanoxid, Cadmiumstannat und/oder Zinkstannat.

Die Antireflexionsschicht vermindert Reflexionen im sichtbaren Spektralbereich an der erfindungsgemäßen Fensterscheibe. Durch die Antireflexionsschicht wird insbesondere eine hohe Transmission im sichtbaren Spektralbereich durch die erfindungsgemäße Fensterscheibe erreicht sowie ein neutralerer Farbeindruck von reflektiertem und transmittiertem Licht. Die Antireflexionsschicht verbessert zudem die Korrosionsbeständigkeit der funktionellen Schicht. Das Material der Antireflexionsschicht weist bevorzugt einen Brechungsindex auf, der kleiner als der Brechungsindex des Materials der funktionellen Schicht ist. Der Brechungsindex des Materials der Antireflexionsschicht beträgt bevorzugt kleiner oder gleich 1,8.

Beispielhafte Schichtsysteme, die als Low-E-Beschichtung geeignet sind sowie Verfahren zu deren Herstellung, sind beispielsweise aus der WO 2013/131667 A1 bekannt.

In der erfindungsgemäßen Fensterscheibe sind mehrere kapazitive Schaltbereiche durch mindestens eine beschichtungsfreie Trennlinie aus der Low-E-Beschichtung elektrisch abgetrennt. Das bedeutet, dass die durch die Trennlinie abgetrennten Bereiche voneinander elektrisch isoliert sind. Die durch die Trennlinie abgetrennten Bereiche sind vorteilhafterweise galvanisch voneinander isoliert.

Gemäß einer bevorzugten Ausführungsform ist der Erfassungsbereich zur Erzeugung eines elektrischen Feldes vorgesehen. Das elektrische Feld erstreckt sich innerhalb des Aktivierungsbereichs. Wird ein Gegenstand in den Aktivierungsbereich bewegt, bewirkt der Gegenstand eine Änderung des elektrischen Feldes, die durch den kapazitiven Schaltbereich erfasst wird. Diese Änderung ist von der Position des Gegenstandes abhängig, so dass auch eine Erfassung der Position möglich ist.

Die kapazitiven Schaltbereiche einer erfindungsgemäßen Fensterscheibe können zur elektrischen Steuerung einer Funktion innerhalb oder außerhalb der Fenster- oder Verbundscheibe, bevorzugt einer Änderung der optischen Transparenz einer funktionellen Zwischenschicht, insbesondere einer Suspended Particle Device (SPD)-Schicht, Polymer Dispersed Liquid Crystal (PDLC)-Schicht oder einer elektrochromen Zwischenschicht, der Fensterscheibe einer Heizfunktion, einer Beleuchtung, insbesondere eines an oder in der Fensterscheibe angeordneten Leuchtmittels, wie einer LED verwendet werden.

Die Änderung der Transparenz kann stufenweise erfolgen. Somit wird es möglich sogar einen stufenweisen Sonnenschutz zu realisieren und auf den Einbau eines herkömmlichen, mechanischen Sonnenschutz-Rollos zu verzichten.

Besonders vorteilhaft ist, dass der Erfassungsbereich den Gegenstand und dessen Bewegungsrichtung detektieren kann. Somit wird nicht nur eine Änderung der Transparenz bewirkt, sondern auch die Richtung der Änderung erfasst. So kann eine Wischgeste einer Person entlang der Fensterscheibe in eine erste Richtung eine stufenweise Verdunkelung bewirken und eine Wischgeste einer Person in die Gegenrichtung eine Reduzierung der Verdunkelung bewirken.

Erfindungsgemäß ist der Erfassungsbereich in zumindest zwei streifenförmige Teilbereiche ausgebildet, deren Länge deutlich größer ist als ihre Breite. Dadurch wird der Aktivierungsbereich erweitert und die Empfindlichkeit der kapazitiven Schaltbereichs gesteigert.

Eine Aufteilung des Erfassungsbereichs in mehrere Teilbereiche ermöglicht eine Erfassung eines Gegenstands in Abhängigkeit seiner Position.

In einer solchen Anordnung bilden jeweils zwei benachbarte Teilbereiche zwei Elektroden aus, die kapazitiv miteinander gekoppelt sind. Die Kapazität des von den Elektroden gebildeten Kondensators ändert sich bei Annäherung eines Gegenstands, vorzugsweise einer menschlichen Hand. Die Kapazitätsänderung wird durch eine Sensorelektronik gemessen und bei Überschreiten eines Schwellwerts wird ein Schaltsignal ausgelöst. Der sensitive Bereich wird durch Form und Größe des Bereichs, in denen die Elektroden kapazitiv gekoppelt sind, festgelegt. Einer der zwei benachbarten Teilbereiche kann dabei an ein Erdpotential gekoppelt sein.

Die Teilbereiche sind in einem der Breite der Trennungslinie entsprechenden und beschichtungsfreien Abstand angeordnet. Eine Längsachse der Teilbereiche verläuft parallel zu einer Seite der innenseitigen Oberfläche. Dabei weist ein Teilbereich eine Länge auf, die einer Seite, der innenseitigen

Oberfläche entsprechen. Die jeweilige Breite eines Teilbereichs kann dabei konstant sein. Alternativ kann die Breite der Teilebereiche variieren. Durch eine parallele Anordnung der Teilbereiche kann nahezu die gesamte innenseitige Oberfläche als Erfassungsbereich dienen. Der an ein Erdpotential gekoppelter Teilbereich kann dabei eine wesentlich geringere Breite als sein benachbarter Teilbereich aufweisen. So kann beispielsweise ein Teilbereich etwa zehnfach breiter ausgebildet sein als sein benachbarter an ein Erdpotential gekoppelter Teilbereich.

Durch die Anordnung der Teilbereiche wird es möglich, dass sich der Aktivierungsbereich über eine parallele Fläche zu der innenseitigen Oberfläche in Richtung des Innenraums erstreckt. Dabei kann bevorzugt der Aktivierungsbereich eine Breite von weniger oder gleich 10 cm aufweisen. Mit Hilfe des vorgesehenen Aktivierungsbereichs kann berührungslos ein Gegenstand, beispielsweise eine menschliche Hand, erfasst und ein Signal generiert werden.

Der erfindungsgemäße kapazitive Schaltbereich kann einen Erfassungsbereich, einen Zuleitungsbereich und einen Anschlussbereich aufweisen, wobei der Zuleitungsbereich den Erfassungsbereich mit dem Anschlussbereich elektrisch verbindet und der Anschlussbereich mit einer Sensorelektronik elektrisch verbindbar ist.

In einer vorteilhaften Ausgestaltung der Erfindung beträgt das Verhältnis von Länge zu Breite des Zuleitungsbereichs kleiner oder gleich 1:700 und bevorzugt von 1:3 bis 1:100. Weist der Zuleitungsbereich keine konstante Breite auf, beispielsweise wenn er trapezförmig oder tropfenförmig ausgebildet ist, so wird im Rahmen der vorliegenden Erfindung unter der Breite die gemittelte Breite des Zuleitungsbereichs verstanden.

Die Länge des Zuleitungsbereichs beträgt 1 cm bis 70 cm, bevorzugt von 1 cm bis 12 cm und insbesondere von 3 cm bis 8 cm. Die Breite des Zuleitungsbereichs beträgt bevorzugt von 0,5 mm bis 10 mm und besonders bevorzugt von 0,5 mm bis 2 mm. Die Form des Zuleitungsbereichs ist bevorzugt rechteckförmig, streifenförmig oder linienförmig. Der Zuleitungsbereich kann geradlinig, aber auch gebogen, abgewinkelt, L-förmig, U-förmig oder beliebig krummlinig ausgebildet sein. Der Zuleitungsbereich lässt sich dabei einfach an die jeweiligen Gegebenheiten der Scheibe, wie von der Low-E-Beschichtung freien Zonen, anpassen und beispielsweise an diesen vorbei führen.

Der Erfassungsbereich kann prinzipiell jede beliebige Form aufweisen. Besonders geeignete Erfassungsbereiche sind tropfenförmig ausgebildet. Alternativ sind eckige Formen möglich, beispielsweise Dreiecke, Quadrate, Rechtecke, Trapeze oder anders geartete Vierecke oder Polygone höherer Ordnung. Besonders vorteilhaft sind, abgerundete Ecken. Dies gilt für im Übergangsbereich zwischen Erfassungsbereich und Zuleitungsbereich und/oder Zuleitungsbereich und Anschlussbereich. Besonders vorteilhaft ist es, wenn die Ecken einen Krümmungsradius von mindestens 3 mm, bevorzugt von mindestens 8 mm aufweisen.

In einer vorteilhaften Ausgestaltung der erfindungsgemäßen Scheibe, beträgt die Breite t₁ der Trennlinien von 30 µm bis 200 µm und bevorzugt von 70 µm bis 140 µm. Derartig dünne Trennlinien erlauben eine sichere und ausreichend hohe elektrische Isolierung und stören gleichzeitig die Durchsicht durch die Verbundscheibe nicht oder nur geringfügig.

In einer vorteilhaften Ausgestaltung bildet der Schaltbereich dabei eine Flächenelektrode aus. Über eine externe kapazitive Sensorelektronik wird die Kapazität der Flächenelektrode gemessen. Die Kapazität der Flächenelektrode ändert sich gegen Erde, wenn ein geeigneter Gegenstand (vorzugsweise eine menschliche Hand), in ihre Nähe kommt. Die Kapazitätsänderung wird durch die Sensorelektronik gemessen und bei Überschreiten eines Schwellwerts wird ein Schaltsignal ausgelöst. Der Schaltbereich wird durch Form und Größe der Flächenelektrode festgelegt.

Der Bereich der Low-E-Beschichtung, der außerhalb des kapazitiven Schaltbereichs angeordnet ist - im Folgenden Umgebungsbereich genannt - kann über einen weiteren Anschlussbereich mit der Sensorelektronik verbindbar oder verbunden sein. Der Umgebungsbereich kann die gesamte Low-E-Beschichtung außerhalb des kapazitiven Schaltbereichs umfassen. Alternativ kann der Umgebungsbereich durch eine oder mehrere Trennlinien von der gesamten Low-E-Beschichtung abgetrennt sein und elektrisch vom kapazitiven Schaltbereich und der umgebenden Low-E-Beschichtung abgetrennt sein. Die Trennlinie, die den kapazitiven Schaltbereich umrandet und den Umgebungsbereich von der restlichen umliegend angeordneten Low-E-Beschichtung abtrennt, hat bevorzugt einen Abstand von 0,1 mm bis 200 mm, besonders bevorzugt von 0,5 mm bis 100 mm und insbesondere einen Abstand von 1 mm bis 11 mm. Der Abstand entspricht somit der Breite des Umgebungsbereichs. Der Umgebungsbereich kann alle kapazitiven Schaltbereiche, jeweils einen einzelnen kapazitiven Schaltbereich oder einzelne Gruppen von kapazitiven Schaltbereichen umranden.

Der erfindungsgemäße kapazitive Schaltbereich und gegebenenfalls der Umgebungsbereich sind in die erfindungsgemäße Fensterscheibe integriert. Es ist also kein Schalter oder ähnliches als separates Bauteil nötig, welches an der Fensterscheibe angebracht werden muss. Die Fensterscheibe weist bevorzugt auch keine sonstigen Bauteile auf, die im Durchsichtbereich auf ihren Oberflächen angeordnet sind. Das ist besonders vorteilhaft im Hinblick auf eine dünne Bauweise der Fensterscheibe sowie einer nur geringen Störung der Durchsicht durch die Fensterscheibe.

Ein weiterer Aspekt der Erfindung umfasst eine Verbundscheibe mit kapazitivem Schaltbereich und einer Beschichtung, mindestens umfassend:
- eine Innenscheibe, die aus einer erfindungsgemäßen Scheibe mit kapazitiven Schaltbereich und der Beschichtung besteht,
- eine Außenscheibe mit einer innenseitigen Oberfläche und
- mindestens einer Zwischenschicht, die die innenseitige Oberfläche der Außenscheibe flächig mit einer außenseitigen Oberfläche der Innenscheibe verbindet.

Die innenseitige Oberfläche der Verbundscheibe entspricht somit der innenseitigen Oberfläche der Innenscheibe (also der erfindungsgemäßen Scheibe) und die außenseitige Oberfläche der Verbundscheibe entspricht der außenseitigen Oberfläche der Außenscheibe.

Im Falle einer Verbundscheibe, werden die Innenscheibe und die Außenscheiben durch mindestens eine Zwischenschicht miteinander verbunden. Die Zwischenschicht ist bevorzugt transparent. Die Zwischenschicht enthält vorzugsweise mindestens einen Kunststoff, bevorzugt Polyvinylbutyral (PVB), Ethylenvinylacetat (EVA) und/oder Polyethylenterephthalat (PET). Die Zwischenschicht kann aber auch beispielsweise Polyurethan (PU), Polypropylen (PP), Polyacrylat, Polyethylen (PE), Polycarbonat (PC), Polymethylmetacrylat, Polyvinylchlorid, Polyacetatharz, Gießharze, Acrylate, fluorinierte Ethylen-Propylene, Polyvinylfluorid und/oder Ethylen-Tetrafluorethylen, oder Copolymere oder Gemische davon enthalten. Die Zwischenschicht kann durch eine oder auch durch mehrere übereinander angeordnete Folien ausgebildet werden, wobei die Dicke einer Folie bevorzugt von 0,025 mm bis 1 mm beträgt, typischerweise 0,38 mm oder 0,76 mm. Die Zwischenschichten können bevorzugt thermoplastisch sein und nach der Lamination die Innenscheibe, die Außenscheibe und eventuelle weitere Zwischenschichten miteinander verkleben. Die Zwischenschicht hat bevorzugt eine relative Permittivität von 2 bis 4 und besonders bevorzugt von 2,1 bis 2,9.

Ein vorteilhafter Aspekt der Erfindung umfasst eine Scheibenanordnung mit einer erfindungsgemäßen Fensterscheibe oder einer erfindungsgemäßen Verbundscheibe und einer Sensorelektronik, die über den Anschlussbereich mit dem kapazitiven Schaltbereich und gegebenenfalls über einen weiteren Anschlussbereich mit der Umgebungsfläche elektrisch verbunden ist. Die Sensorelektronik ist eine kapazitive Sensorelektronik.

In einer vorteilhaften Ausgestaltung der erfindungsgemäßen Schaltanordnung ist die Empfindlichkeit der Sensorelektronik so gewählt, dass die Sensorelektronik bei einer Erfassung eines von einer Person in einem Aktivierungsbereich bewegten Gegenstands ein Schaltsignal generiert.

Es versteht sich, dass der Erfassungsbereich auch mehrere Finger oder einem anderen menschlichen Körperteil detektieren kann. Unter Erfassung wird im Rahmen dieser Erfindung jegliche Wechselwirkung mit dem Schaltbereich verstanden, die zu einer messbaren Änderung des Messsignals, also hier der Kapazität, führt.

Die ausgegebenen Schaltsignale können beliebig und den Erfordernissen der jeweiligen Verwendung angepasst sein. So kann das Schaltsignal eine positive Spannung, beispielsweise 12 V, bedeuten, kein Schaltsignal beispielsweise 0 V bedeuten und ein anderes Schaltsignal beispielweise + 6 V bedeuten. Die Schaltsignale können auch den bei einem CAN-Bus üblichen Spannungen CAN_High und CAN_Low entsprechen und um einen dazwischen liegenden Spannungswert wechseln. Das Schaltsignal kann auch gepulst und/oder digital codiert sein.

Der besondere Vorteil einer solchen erfindungsgemäßen Scheibenanordnung liegt darin, dass das Schaltsignal keiner Berührung der Fensterscheibe bzw. der Verbundscheibe bedarf.

Die Empfindlichkeit der Sensorelektronik kann in Abhängigkeit der Größe des Erfassungsbereichs und in Abhängigkeit der Geometrie sowie des Verhältnisses zwischen Breite und Länge des Zuleitungsbereichs im Rahmen einfacher Experimente ermittelt werden. Besonders vorteilhaft ist es dabei, wenn die Breite des Zuleitungsbereichs möglichst gering gewählt wird. Insbesondere eine Änderung der Vergleichskapazität der angeschlossenen Sensorelektronik führt ebenfalls zu einer starken Sensitivierung des Schaltbereichs.

In einer vorteilhaften Weiterbildung einer erfindungsgemäßen Scheibenanordnung ist der Anschlussbereich mit einem Flachleiter, einem metallischen Draht, insbesondere einem Rundleiter oder einem litzenförmigen Leiter verbunden und von der Scheibenoberfläche weggeführt. Die integrierte Scheibenanordnung kann dann besonders einfach am Verwendungsort mit einer Spannungsquelle und einer Signalleitung verbunden werden, die das Schaltsignal der Sensorschaltung auswertet, beispielsweise in einem Fahrzeug über einen CAN-Bus.

Als Scheibe bzw. Innenscheibe und Außenscheibe sind im Grunde alle elektrisch isolierenden Substrate geeignet, die unter den Bedingungen der Herstellung und der Verwendung der erfindungsgemäßen Fenster- oder Verbundscheibe thermisch und chemisch stabil sowie dimensionsstabil sind.

Die Scheibe bzw. die Innenscheibe und die Außenscheibe enthalten bevorzugt Glas, besonders bevorzugt Flachglas, Floatglas, Quarzglas, Borosilikatglas, Kalk-Natron-Glas, oder klare Kunststoffe, vorzugsweise starre klare Kunststoffe, insbesondere Polyethylen, Polypropylen, Polycarbonat, Polymethylmethacrylat, Polystyrol, Polyamid, Polyester, Polyvinylchlorid und/oder Gemische davon. Die Scheibe bzw. die Innenscheibe und die Außenscheibe sind bevorzugt transparent, insbesondere für die Verwendung der Scheibe als Windschutzscheide oder Rückscheibe eines Fahrzeugs oder anderen Verwendungen bei denen eine hohe Lichttransmission erwünscht ist. Als transparent im Sinne der Erfindung wird dann eine Scheibe verstanden, die eine Transmission im sichtbaren Spektralbereich von größer 70 % aufweist. Für Scheiben, die nicht im verkehrsrelevanten Sichtfeld des Fahrers liegen, beispielsweise für Dachscheiben, kann die Transmission aber auch viel geringer sein, beispielsweise größer als 5 %.

Die Dicke von der Scheibe bzw. der Innenscheibe und der Außenscheibe kann breit variieren und so hervorragend den Erfordernissen des Einzelfalls angepasst werden, insbesondere um ein asymmetrisches Schalten zu realisieren.. Vorzugsweise werden Standardstärken von 1,0 mm bis 25 mm, bevorzugt von 1,4 mm bis 2,5 mm für Fahrzeugglas und bevorzugt von 4 mm bis 25 mm für Möbel, Geräte und Gebäude, verwendet. Die Größe der Fenster- und der Verbundscheibe kann breit variieren und richtet sich nach der Größe der erfindungsgemäßen Verwendung. Fenster- und Verbundscheibe weisen beispielsweise im Fahrzeugbau und Architekturbereich übliche Flächen von 200 cm² bis zu 20 m² auf.

Die Fenster- oder Verbundscheibe kann eine beliebige dreidimensionale Form aufweisen. Vorzugsweise hat die dreidimensionale Form keine Schattenzonen, so dass sie beispielsweise durch Kathodenzerstäubung beschichtet werden kann. Bevorzugt sind die Scheiben plan oder leicht oder stark in einer Richtung oder in mehreren Richtungen des Raumes gebogen. Insbesondere werden plane Scheiben verwendet. Die Scheiben können farblos oder gefärbt sein.

Die Scheibe bzw. Innenscheibe und die Außenscheibe weisen bevorzugt eine relative Permittivität ε_{r,1/4} von 2 bis 8 und besonders bevorzugt von 6 bis 8 auf.

In einer vorteilhaften Ausgestaltung der erfindungsgemäßen Fensterscheibe oder der erfindungsgemäßen Verbundscheibe ist der Anschlussbereich am äußeren Rand der Scheibe angeordnet. Dabei beträgt der Abstand zum äußeren Rand bevorzugt weniger als 10 cm, besonders bevorzugt weniger als 0,5 cm. Dies erlaubt es eine elektrische Kontaktierung des Anschlussbereichs, beispielsweise mit einem Folienleiter, unter einem optisch unauffälligen Schwarzdruck oder mit einer Abdeckung.

Die elektrische Zuleitung ist bevorzugt als Folienleiter oder flexibler Folienleiter (Flachleiter, Flachbandleiter) ausgebildet. Unter Folienleiter wird ein elektrischer Leiter verstanden, dessen Breite deutlich größer ist als seine Dicke. Ein solcher Folienleiter ist beispielsweise ein Streifen oder Band enthaltend oder bestehend aus Kupfer, verzinntem Kupfer, Aluminium, Silber, Gold oder Legierungen davon. Der Folienleiter weist beispielsweise eine Breite von 2 mm bis 16 mm und eine Dicke von 0,03 mm bis 0,1 mm auf. Der Folienleiter kann eine isolierende, bevorzugt polymere Ummantelung, beispielsweise auf Polyimid-Basis aufweisen. Folienleiter, die sich zur Kontaktierung von elektrisch leitfähigen Beschichtungen in Scheiben eignen, weisen lediglich eine Gesamtdicke von beispielsweise 0,3 mm auf. Derart dünne Folienleiter können einfach und ästhetisch auf der innenseitigen Oberfläche angeordnet und beispielsweise auf geklebt werden. In einem Folienleiterband können sich mehrere voneinander elektrisch isolierte, leitfähige Schichten befinden.

Die elektrische Leitungsverbindung zwischen dem Anschlussbereich und der elektrischen Zuleitung erfolgt bevorzugt über elektrisch leitfähige Kleber, die eine sichere und dauerhaft elektrische Leitungsverbindung zwischen Anschlussbereich und Zuleitung ermöglichten. Alternativ kann die elektrische Leitungsverbindung auch durch Klemmen oder Federkontakte erfolgen. Alternativ kann die Zuleitung auch auf den Anschlussbereich aufgedruckt werden, beispielsweise mittels einer eingebrannten metallhaltigen und insbesondere silberhaltigen, elektrisch leitfähigen Druckpaste oder Lötung, insbesondere Ultraschalllötung.

In einer vorteilhaften Ausgestaltung der erfindungsgemäßen Fensterscheibe oder Verbundscheibe ist der Erfassungsbereich durch eine aktive, dimmbare Lichtquelle direkt markierbar oder markiert, bevorzugt durch eine Leuchtdiode (LED), eine organische Leuchtdiode (OLED) oder andere aktive Leuchtkörper, wie ein lumineszentes Material, bevorzugt ein fluoreszierende oder phosphoreszierendes Material.

Die Lichtquelle umfasst bevorzugt eine LED oder OLED. Der besondere Vorteil liegt in den kleinen Abmessungen und der geringen Leistungsaufnahme. Der von der Lichtquelle emittierte Wellenlängenbereich kann im Bereich des sichtbaren Lichtes frei gewählt werden, beispielsweise nach praktischen und/oder ästhetischen Gesichtspunkten.

Das Lichtmittel kann an einer beliebigen Stelle der Scheibe bzw. der Innenscheibe oder Außenscheibe angeordnet sein, insbesondere über einen Sitz und am Seitenrand der Fensterscheibe oder Verbundscheibe oder in einer kleinen Ausnehmung inmitten von Innenscheibe und Außenscheibe. Vorzugsweise ist die Lichtquelle mittig im Erfassungsbereich angeordnet.

Ein weiterer Aspekt der Erfindung umfasst ein Verfahren zur Herstellung einer Fensterscheibe mit kapazitivem Schaltbereich, mindestens umfassend:
(a) Aufbringen einer Beschichtung auf eine innenseitige Oberfläche einer Scheibe,
(b) Einbringen mindestens einer Trennlinie, die Beschichtung in mehrere kapazitive Schaltbereiche und/oder mindestens einen Umgebungsbereich elektrisch unterteilt, bevorzugt durch Laserstrukturierung oder durch mechanisches oder chemisches Abtragen.

In einer alternativen Ausführungsform des erfindungsgemäßen Verfahrens zur Herstellung einer Verbundscheibe mit kapazitivem Schaltbereich können die Verfahrensschritte a) und b) auch vertauscht sein.

Das Aufbringen der Beschichtung kann durch an sich bekannte Verfahren erfolgen, bevorzugt durch magnetfeldunterstützte Kathodenzerstäubung. Das ist besonders vorteilhaft im Hinblick auf eine einfache, schnelle, kostengünstige und gleichmäßige Beschichtung der Scheiben. Die elektrisch leitfähigen Schicht kann aber auch beispielsweise durch Aufdampfen, chemische Gasphasenabscheidung (chemical vapour deposition, CVD), plasmagestützte Gasphasenabscheidung (PECVD) oder durch nasschemische Verfahren aufgebracht werden.

Die Entschichtung einzelner Trennlinien in der Beschichtung erfolgt vorzugsweise durch einen Laserstrahl.

Das Laminieren, also das Verbinden von Innenscheibe, Zwischenschicht und Außenscheibe erfolgt bevorzugt unter Einwirkung von Hitze, Vakuum und/oder Druck. Es können an sich bekannte Verfahren zur Herstellung einer Verbundscheibe verwendet werden.

Ein weiterer Aspekt der Erfindung umfasst die Verwendung der erfindungsgemäßen Fensterscheibe oder Verbundscheibe mit kapazitivem Schaltbereich in Gebäuden, insbesondere im Zugangsbereich, Fensterbereich, Dachbereich oder Fassadenbereich, als Einbauteil in Möbeln und Geräten, in Fortbewegungsmitteln für den Verkehr auf dem Lande, in der Luft oder zu Wasser, insbesondere in Zügen, Schiffen und Kraftfahrzeugen beispielsweise als Windschutzscheibe, Heckscheibe, Seitenscheibe und/oder Dachscheibe.

Ein weiterer Aspekt der Erfindung umfasst die Verwendung der erfindungsgemäßen Fensterscheibe mit mehreren kapazitiven Schaltbereichen oder der Verbundscheibe zur elektrischen Steuerung einer Funktion innerhalb oder außerhalb der Verbundscheibe , bevorzugt einer Heizfunktion, einer Beleuchtung, insbesondere eines in der Verbundscheibe angeordneten Leuchtmittels wie einer LED, einer Änderung der optischen Transparenz einer funktionellen Zwischenschicht, insbesondere einer Suspended Particle Device (SPD)-Schicht oder einer elektrochromen Zwischenschicht.

Im Folgenden wird die Erfindung anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein.

Es zeigen:
- Figur 1A: eine Draufsicht auf eine Ausgestaltung einer erfindungsgemäßen Scheibenanordnung mit einer erfindungsgemäßen Fensterscheibe;
- Figur 1B: eine Querschnittsdarstellung entlang der Schnittlinie A-A' aus Figur 1A;
- Figur 2: eine Draufsicht auf eine alternative Ausgestaltung einer erfindungsgemäßen Scheibenanordnung mit mehreren kapazitiven Schaltbereichen;
- Figur 3: eine Draufsicht auf eine weitere alternative Ausgestaltung einer erfindungsgemäßen Scheibenanordnung mit einer erfindungsgemäßen Verbundscheibe und mit mehreren kapazitiven Schaltbereichen;
- Figur 4: eine Draufsicht auf eine weitere alternative Ausgestaltung einer erfindungsgemäßen Scheibenanordnung mit einer erfindungsgemäßen Verbundscheibe und mit mehreren kapazitiven Schaltbereichen zur Steuerung einer Lichtquelle, und
- Figur 5: ein detailliertes Flussdiagramm einer Ausführungsform des erfindungsgemäßen Verfahrens zur Herstellung einer Fensterscheibe.

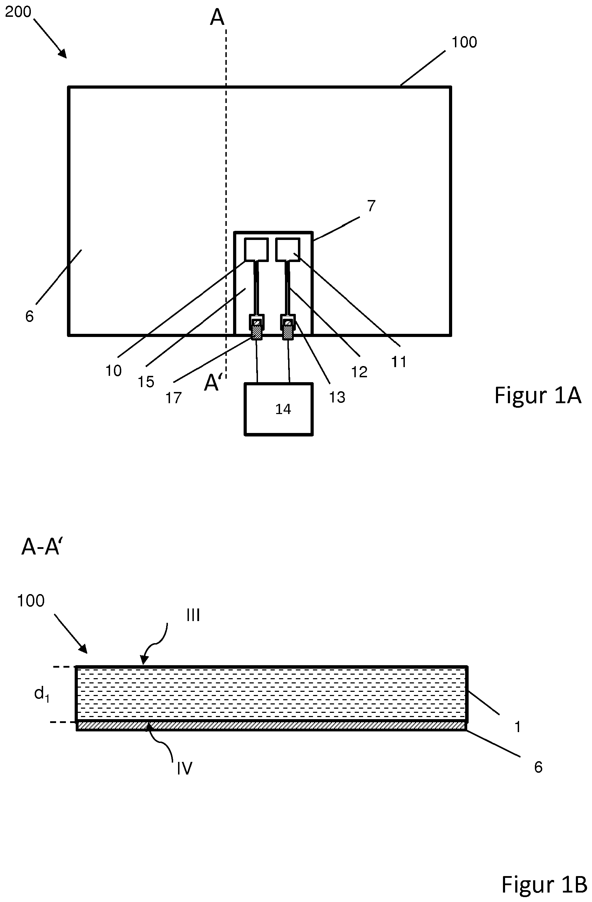

Figur 1A zeigt eine Draufsicht auf eine beispielhafte Ausgestaltung einer erfindungsgemäßen Scheibenanordnung 200 mit einer erfindungsgemäßen Fensterscheibe 100 am Beispiel einer Dachscheibe eines Kraftfahrzeugs.

Die Fensterscheibe 100 weist über ihre nahezu gesamte Oberfläche eine Beschichtung 6 auf. Die Beschichtung 6 ist eine sogenannte Low-E-Beschichtung 6, die durch beschichtungsfreie Trennlinien 7 in unterschiedliche, voneinander elektrisch isolierte Bereiche unterteilt ist. In diesem Beispiel bedeutet elektrisch isolierte, dass die Bereiche voneinander galvanisch getrennt sind, das heißt, dass kein Gleichstrom (DC) zwischen den Bereichen fließen kann.

Die Trennlinie 7 hat lediglich eine Breite von beispielsweise 100 µm und ist beispielsweise durch Laserstrukturierung in die Low-E-Beschichtung 6 eingebracht. Trennlinien 7 mit einer derart geringen Breite sind optisch kaum wahrnehmbar und stören die Durchsicht durch die Fensterscheibe 100 nur wenig, was besonders ästhetisch ist und besonders für eine Verwendung im Sichtbereich von Fahrzeugen von besonderer Wichtigkeit für die Fahrsicherheit ist.

Im unteren Abschnitt der Fensterscheibe 100 weist die Low-E-Beschichtung 6 beispielsweise zwei kapazitive Schaltbereiche 10 auf. Die zwei kapazitiven Schaltbereiche 10 sind von einem gemeinsamen Umgebungsbereich 15 elektrisch unterteilt. Jeder Schaltbereich 10 umfasst einen Erfassungsbereichsbereich 11, der annähernd quadratisch ausgebildet ist und in einen streifenförmigen Zuleitungsbereich 12 übergeht. Die Breite und die Länge des Erfassungsbereichs 11 beträgt jeweils beispielsweise 40 mm.

Der kapazitive Schaltbereich 10 erzeugt ein elektrisches Feld, das sich innerhalb eines Aktivierungsbereichs erstreckt. Der Aktivierungsbereich ist über eine parallele Fläche zu der innenseitigen Oberfläche angeordnet und erstreckt sich in Richtung des Innenraums. Dabei kann bevorzugt der Aktivierungsbereich eine Breite von weniger oder gleich 10 cm in Richtung des Innenraums aufweisen. Mit Hilfe des vorgesehenen Aktivierungsbereichs kann berührungslos ein Gegenstand, beispielsweise eine menschliche Hand, erfasst und ein Signal generiert werden. Wird ein Gegenstand in den Aktivierungsbereich bewegt, bewirkt der Gegenstand eine Änderung des elektrischen Feldes, die durch den kapazitiven Schaltbereich erfasst wird.

Die Breite des Zuleitungsbereichs 12 beträgt beispielsweise 1 mm. Der Zuleitungsbereich 12 ist mit einem Anschlussbereich 13 verbunden. Der Anschlussbereich 13 hat eine rechteckige, insbesondere quadratische Form und eine Kantenlänge von beispielsweise 12 mm. Die Länge des Zuleitungsbereichs beträgt etwa 48 mm. Der Umgebungsbereich 15 ist wiederum durch eine Trennlinie 7 von der restlichen Low-E-Beschichtung 6 abgetrennt. Der Umgebungsbereich 15 ist hier rechteckig ausgestaltet und umfasst beide kapazitiven Schaltbereiche 10.

Der Anschlussbereich 13 ist über eine elektrische Leitungsverbindung mit einem Folienleiter 17 elektrisch leitend verbunden. Eine sichere elektrisch leitende Verbindung wird dabei bevorzugt durch einen elektrisch leitfähigen Kleber erzielt. Der Folienleiter 17 besteht beispielsweise aus einer 50 µm dicken Kupferfolie und ist beispielsweise außerhalb der Anschlussbereichs 13 mit einer Polyimidschicht isoliert. Dadurch kann der Folienleiter 17 ohne elektrischen Kurzschluss über den Umgebungsbereich 15 hinweg über den unteren Rand der Fensterscheibe 100 hinausgeführt werden. Es versteht sich, dass die elektrische Leitungsverbindung des Anschlussbereichs nach außen auch über isolierte Drähte oder über einen Bereich, in dem die Low-E-Beschichtung des Umgebungsbereichs unterbrochen ist, nach außen geführt werden kann.

Der Folienleiter 17 ist hier beispielsweise außerhalb der Fensterscheibe 100 mit einer kapazitiven Sensorelektronik 14 verbunden. Die Sensorelektronik 14 ist dazu geeignet Kapazitätsänderungen des Schaltbereichs 10 gegenüber dem Umgebungsbereich 15 präzise zu messen und in Abhängigkeit eines Schwellwerts ein Schaltsignal beispielsweise an den CAN-Bus eines Fahrzeugs weiter zu geben. Über das Schaltsignal können beliebige Funktionen im Fahrzeug geschaltet werden. Beispielsweise kann eine Beleuchtung in oder an der Fensterscheibe 100 ein- oder ausgeschaltet werden.

Wird die Fensterscheibe 100 beispielsweise als Dachscheibe in einem Kraftfahrzeug verwendet, kann die Länge des Zuleitungsbereichs 12 so gewählt werden, dass der Fahrer des Fahrzeugs, der Beifahrer oder Insassen auf der Rückbank des Fahrzeugs den Erfassungsbereich 11 des Schaltbereichs 10 bequem erreichen.

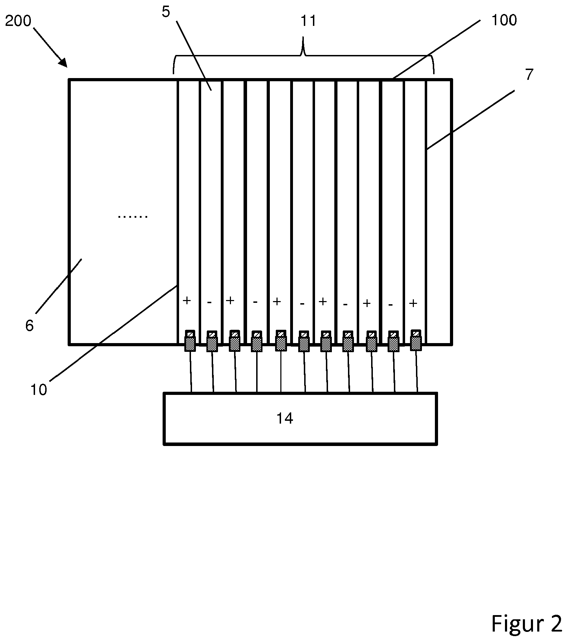

Im dargestellten Ausgestaltungsbeispiel ist der Aufbau und die Abstimmung der Sensorelektronik 14 derart abgestimmt, dass bei eine Bewegung einer Hand innerhalb des Aktivierungsbereichs, d.h. in der Nähe der innenseitigen Oberfläche IV in Fig. 2 der Scheibe 1 über dem Erfassungsbereich 11 des kapazitiven Schaltbereichs 10, ein Schaltsignal ausgelöst wird.

In Figur 1B ist eine Querschnittsdarstellung entlang der Schnittlinie A-A' aus Figur 1A dargestellt. Die Fensterscheibe 100 umfasst hier beispielsweise eine einzelne Scheibe 1. Die Fensterscheibe 100 ist beispielsweise eine Fahrzeugscheibe und insbesondere die Dachscheibe eines Personenkraftwagens. Die Abmessungen der Fensterscheibe 100 betragen beispielsweise 0,9 m x 1,5 m. Die Fensterscheibe 100 enthält eine Scheibe 1, die beispielsweise dafür vorgesehen ist, in Einbaulage einen Fahrzeuginnenraum von einer äußeren Umgebung abzutrennen. Das heißt, die innenseitige Oberfläche IV der Scheibe 1 ist vom Innenraum aus zugänglich, wogegen die außenseitige Oberfläche III der Scheibe 1 bezüglich des Fahrzeuginnenraums nach außen weist. Die Scheibe 1 besteht beispielsweise aus Natron-Kalkglas und wurde im Floatverfahren hergestellt. Die Dicke d₁ der Scheibe 1 beträgt beispielsweise 2,1 mm. Prinzipiell kann die Scheibe 1 auch andere Dicken aufweisen. So kann die Scheibe 1 beispielsweise als Bauverglasung eine Dicke von 4 mm aufweisen.

Die innenseitige Oberfläche IV der Scheibe 1 ist mit einer Low-E-Beschichtung 6 beschichtet. In Tabelle 1 sind drei Beispiele für erfindungsgemäße Low-E-Beschichtungen 6 mit funktionellen Schichten aus beispielsweise ITO dargestellt. Jede Low-E-Beschichtung 6 der Beispiele 1-3 besteht aus einem Schichtstapel aus: Scheibe 1 / Haftschicht / funktioneller Schicht / Barriereschicht / Antireflexionsschicht.

**Tabelle 1**

| | Material | Dicke | | |
|---|---|---|---|---|
| | | Beispiel 1 | Beispiel 2 | Beispiel 3 |
| Antireflexionsschicht | SiO₂:Al | 45 nm | 40 nm | 80 nm |
| Barriereschicht | Si₃N₄:Al | 12 nm | 20 nm | 12 nm |
| Funktionelle Schicht | ITO | 120 nm | 120 nm | 120 nm |
| Haftschicht | SiO₂:Al | 30 nm | 30 nm | 40 nm |
| Scheibe bzw. Innenscheibe 1 | Kalk-Natronglas | | | |

Die in Figur 1B dargestellte Low-E-Beschichtung 6 besteht beispielsweise aus dem Schichtsystem nach Beispiel 1 aus Tabelle 1. In einem weiteren Beispiel besteht Low-E-Beschichtung 6 aus dem Schichtsystem nach Beispiel 2 aus Tabelle 1 und in einem weiteren Beispiel aus dem Schichtsystem nach Beispiel 3 aus Tabelle 1.

Die Fensterscheibe 1 mit den beispielhaft genannten Schichtsystemen nach Beispiel 1-3 haben eine innenraumseitige, normale Gesamtemissivität von kleiner oder gleich 30% und einen Flächenwiderstand von 20 Ohm/Quadrat bis 30 Ohm/Quadrat. Die erfindungsgemäße Fensterscheibe weist bei Reflexion beispielsweise einen Farbwert a* von -3 bis +4 und einen Farbwert b* von -7 bis +4 auf, betrachtet von der mit der erfindungsgemäßen Low-E-Beschichtung 6 versehenen Seite aus. Die Angaben a* und b* beziehen sich auf die Farbkoordinaten gemäß dem kolorimetrischen Modell (L*a*b*-Farbraum).

Eine derartige erfindungsgemäße Fensterscheibe 1 kann klar sein und beispielsweise eine Transparenz von größer oder gleich 80% im sichtbaren Bereich aufweisen kann. Zur Vermeidung von Blendung im sichtbaren Bereich durch Sonneneinstrahlung kann die Scheibe 1 auch stark getönt sein und lediglich eine Transparenz von kleiner oder gleich 20% im sichtbaren Bereich aufweisen. Es versteht sich, dass die Low-E-Beschichtung 6 auch aus anderen Schichtsystemen mit niedriger Emissivität bestehen kann.

Figur 2 zeigt eine Draufsicht auf eine alternative Ausgestaltung einer erfindungsgemäßen Scheibenanordnung 200 mit mehreren kapazitiven Schaltbereichen 10. Das dargestellte Ausführungsbeispiel entspricht im Aufbau im Wesentlichen der erfindungsgemäßen Fensterscheibe 100 nach Figur 1A, so dass im Folgenden nur auf die jeweiligen Unterschiede eingegangen wird.

Die kapazitiven Schaltbereiche 10 der Fensterscheibe 100 steuern die optische Transparenz einer funktionellen Zwischenschicht der Scheibenanordnung 200, insbesondere einer Suspended Particle Device (SPD)-Schicht, Polymer Dispersed Liquid Crystal (PDLC)-Schicht oder einer elektrochromen Zwischenschicht,

Der Erfassungsbereich 11 ist in diesem Beispiel in mehrere länglich verlaufene Teilbereich 5 unterteilt. Die Teilbereiche 5 sind streifenförmig über nahezu die gesamte innenseitige Oberfläche der Fensterscheibe 100 ausgebildet. Ein Teilbereich 5 kann eine Breite von 2 cm bis 0,3 cm aufweisen. Alternativ kann jeder Teilbereich 5 eine Länge aufweise, die sich über eine halbe Breite der Fensterscheibe 100 erstreckt, so dass die Fensterscheibe 100 zwei separate Erfassungsbereiche 11 aufweist. Die separaten Erfassungsbereich 11 verfügen jeweils über eine Sensorschaltung 14, die individuell jedem Teilbereich 5 zugeordnet sein kann.

Jeder Teilbereich 5 ist über eine elektrische Leitungsverbindung mit einem Folienleiter 17 elektrisch leitend verbunden. Dabei kann ein Teilbereich 5 über den Folienleiter 17 an ein Erdpotential gekoppelt sein, wobei sein direkter benachbarter Teilbereich 5 über den Folienleiter 17 an ein elektrisches Potential geschaltet ist. Die Folienleiter 17 sind außerhalb der Fensterscheibe 100 mit der kapazitiven Sensorelektronik 14 verbunden. Eine Aufteilung des Erfassungsbereichs in mehrere Teilbereiche 5 ermöglicht eine Erfassung eines Gegenstands in Abhängigkeit seiner Position.

Das elektrische Feld erstreckt sich dabei innerhalb des Aktivierungsbereichs nahezu über die gesamte innenseitige Oberfläche IV der Fensterscheibe 100 in Richtung des Innenraumes. Durch die streifenförmige Ausgestaltung der Teilbereiche 5 wird der Aktivierungsbereich erweitert und die Empfindlichkeit der kapazitiven Schaltbereichs gesteigert.

Wird ein Gegenstand, vorzugsweise eine Hand, in den Aktivierungsbereich bewegt, bewirkt der Gegenstand eine Änderung des elektrischen Feldes, die durch den kapazitiven Schaltbereich erfasst wird. Diese Änderung ist von der Position des Gegenstandes abhängig, so dass auch eine Erfassung der Position möglich ist. Durch die vorteilhafte Ausgestaltung der Teilbereiche 5 in Streifenform erfolgt die Änderung der Transparenz stufenweise, wobei eine Stufe einem Teilbereich 5 entsprechen kann.

Der Erfassungsbereich 11 detektiert den Gegenstand und dessen Bewegungsrichtung. Somit wird nicht nur eine Änderung der Transparenz bewirkt, sondern auch die Richtung der Änderung erfasst. So kann eine Wischgeste einer Person entlang der Fensterscheibe in eine erste Richtung eine stufenweise Verdunkelung bewirken und eine Wischgeste einer Person in die Gegenrichtung eine Reduzierung der Verdunkelung bewirken.

In einer alternativen Ausgestaltung der erfindungsgemäßen Fensterscheibe 100 steuert der kapazitive Schaltbereich 10 die Öffnung und Schließung der Dachscheibe. Dabei wird eine Öffnungs- bzw. Schließungsposition der Seitenscheibe durch die Position und Richtung der Wischgeste der Hand bestimmt.

In einer weiteren Ausgestaltung der erfindungsgemäßen Scheibenanordnung 200 mit einer erfindungsgemäßen Fensterscheibe 100 kann die Scheibenanordnung 200 als Windschutzscheibe eines Kraftfahrzeugs dienen, bei der der obere Bereich stufenweise verdunkelt werden kann.

In einer weiteren alternativen Ausgestaltung der erfindungsgemäßen Scheibenanordnung 200 mit einer erfindungsgemäßen Fensterscheibe 100 kann die Scheibenanordnung 200 als Seitenscheibe eines Kraftfahrzeugs dienen. In einer derartigen Ausgestaltung steuert der kapazitive Schaltbereich 10 die Öffnung und Schließung der Seitenscheibe. Dabei wird eine Öffnungs- bzw. Schließungsposition der Seitenscheibe durch die Position und Richtung der Wischgeste der Hand bestimmt. Zusätzlich kann eine Schließung der Seitenscheibe über eine Knopfsteuerung erfolgen.

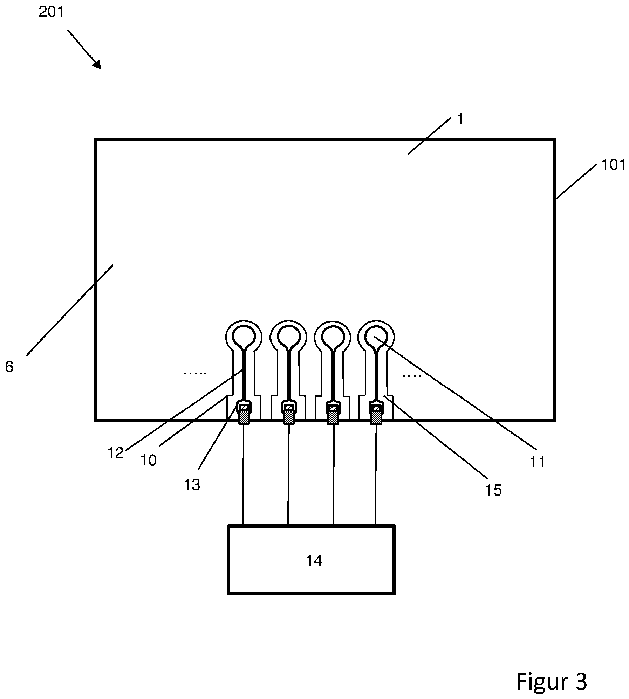

Das in Figur 3 dargestellte Ausführungsbeispiel einer Scheibenanordnung 201 entspricht im Aufbau im Wesentlichen der erfindungsgemäßen Verbundscheibe 101 mit einer Fensterscheibe nach Figur 1A. Die Verbundscheibe 101 umfasst hier beispielsweise eine Innenscheibe 1 und eine Außenscheibe, die über eine Zwischenschicht miteinander verbunden sind. Die Innenscheibe 1 entspricht in ihrer Funktion der Scheibe 1 aus Figur 1A

Im mittleren, unteren Abschnitt der Verbundscheibe 101 weist die Low-E-Beschichtung 6 mehrere kapazitive Schaltbereiche 10 auf, die sich nahezu in paralleler Anordnung über eine Längsseite der Verbundscheibe 101 erstrecken.

Die Low-E-Beschichtung 6 ist durch beschichtungsfreie Trennlinien 7 in unterschiedliche, voneinander elektrisch isolierte Bereiche unterteilt. Jeweils ein kapazitiver Schaltbereich 10 ist von einem Umgebungsbereich 15 elektrisch unterteilt. Jeder Schaltbereich 10 umfasst einen Erfassungsbereich 11, der annähernd tropfenförmig ausgebildet ist und in einen streifenförmigen Zuleitungsbereich 12 übergeht. Die Breite und die Länge des Erfassungsbereichs 11 beträgt jeweils beispielsweise 40 mm. Die Breite des Zuleitungsbereichs 12 beträgt beispielsweise 1 mm. Der Zuleitungsbereich 12 ist mit einem Anschlussbereich 13 verbunden. Der Anschlussbereich 13 hat eine quadratische Form mit abgerundeten Ecken und einer Kantenlänge von beispielsweise 12 mm. Die Länge des Zuleitungsbereichs beträgt etwa 48 mm.

In einer alternativen Ausgestaltung der erfindungsgemäßen Scheibenanordnung 201 mit einer erfindungsgemäßen Fensterscheibe 101 kann die Scheibenanordnung 201 als Seitenscheibe eines Kraftfahrzeugs dienen und kapazitive Schaltbereiche 10 aufweisen, die zur die Öffnung und Schließung der Seitenscheibe vorgesehen sind. Dabei wird eine Öffnungs- bzw. Schließungsposition der Seitenscheibe durch die Position und die Richtung der Wischgeste der Hand bestimmt.

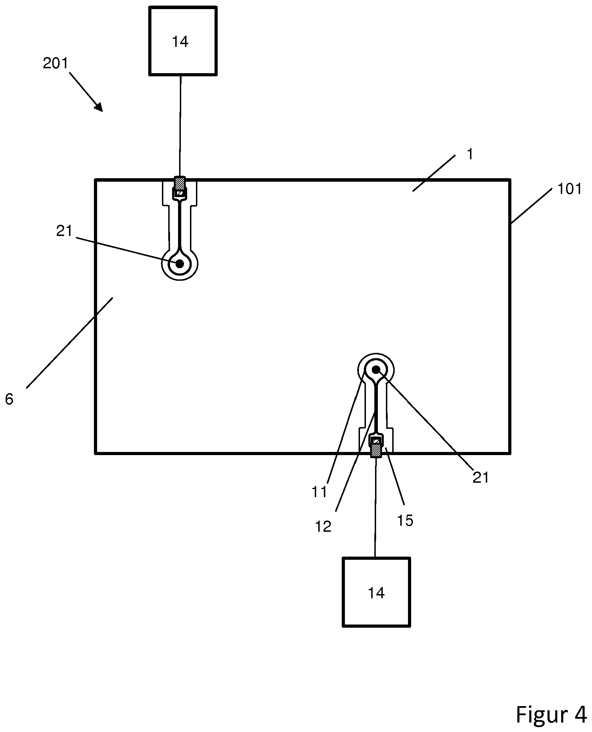

Figur 4 zeigt eine alternative Ausgestaltung bei der eine funktionelle Zwischenschicht zwischen Innenscheibe 1 und Außenscheibe in die Verbundscheibe 101 einlaminiert wurde. Die funktionelle Zwischenschicht ist hier beispielsweise über zwei thermoplastische Zwischenschichten aus einer PVB-Folie mit der Innenscheibe 1 und der Außenscheibe verbunden. Die funktionelle Zwischenschicht weist beispielsweise eine elektrisch steuerbare, optische Transparenz auf und enthält bevorzugt eine Suspended Particle Device (SPD)-Schicht oder eine elektrochrome Zwischenschicht.

Zusätzlich umfasst die Verbundscheibe 101 zwei Leuchtdioden (LED) 21, beispielsweise Multicolor LEDs, zwischen Innenscheibe 1 und Außenscheibe 4, die in die Verbundscheibe 101 einlaminiert wurden. Das Licht der Leuchtdioden 21 markiert den Bereich der kapazitiven Schaltfläche 10 und/oder dient als Beleuchtungsmittel, die jeweils über den dazugehörigen kapazitiven Schaltbereich 10 gesteuert werden kann.

Die Verbundscheibe 101 dient als Dachscheibe in einem Fahrzeug. Dabei kann die Position und die Länge des Erfassungsbereichs 12 so gewählt werden, dass der Fahrer des Fahrzeugs oder Mitfahrer auf ihren jeweiligen Sitzplätzen den Erfassungsbereich 11 des Schaltbereichs 10 bequem erreichen. Es versteht sich, dass dazu auch mehrere kapazitive Schaltflächen 10 in der Verbundscheibe 100 angeordnet werden können, beispielsweise jeweils eine für jeden Fahrzeuginsassen.

Der Aufbau und die Abstimmung der Sensorelektronik 14 ist derart abgestimmt, dass bei einer Erfassung einer Hand des Fahrers oder Mitfahrers im Erfassungsbereich 11 des kapazitiven Schaltbereichs 10 ein Schaltsignal ausgelöst wird.

Alternativ kann die Position der kapazitiven Schaltflächen auch zufällig über der innenseitigen Oberfläche verteilt sein. Mit einer Gestenbewegung des Fahrers oder Mitfahrers, die sich durch eine Richtung und Position auszeichnet, kann die Leuchtdiode 21 gesteuert werden. Dies hat den besonderen Vorteil, dass die Leuchtionen individuell angesteuert werden können und der Fahrer oder Mitfahrer einen auf seine Bedürfnisse abgestimmten Farbwert der Leuchtdiode auswählen kann.

Bei einem weiteren Ausgestaltungsbeispiel einer erfindungsgemäßen Verbundscheibe 101 ist die Verbundscheibe 101 als eine Windschutzscheibe ausgebildet, wobei die Verbundscheibe 101 in einer Ansicht dargestellt wird, die auf die innenseitige Oberfläche IV der Innenscheibe 1 gerichtet ist, also von der Position des Fahrzeugfahrers aus gesehen. Dabei ist der Aufbau und die Abstimmung der Sensorelektronik 14 derart abgestimmt, dass der Fahrzeugfahrer zur Steuerung der Transparenz der Windschutzscheibe seine Hand ins den Erfassungsbereich 11 des kapazitiven Schaltbereichs 10 bewegt um ein Schaltsignal auszulösen. Besonders vorteilhaft ist ein kapazitiver Schaltbereich 10, bei dem eine Erzeugung des Schaltsignals ohne eine Berührung der Windschutzscheibe möglich ist. Die Konzentration und Blickrichtung des Fahrzeug Fahrers wird nicht dadurch abgelenkt, dass seine Hand einen bestimmten Punkt an der Windschutzscheibe berühren muss, sondern durch strecken der Hand in Richtung des Erfassungsbereichs und Erreichen des Aktivierungsbereichs in der Nähe der innenseitige Oberfläche IV wird ein Schaltsignal ausgelöst. Ein weiterer Vorteil einer berührungslosen Steuerung besteht darin, dass der Fahrzeugfahrer die Windschutzscheibe nicht durch Fingerabdrücke verschmutzt.

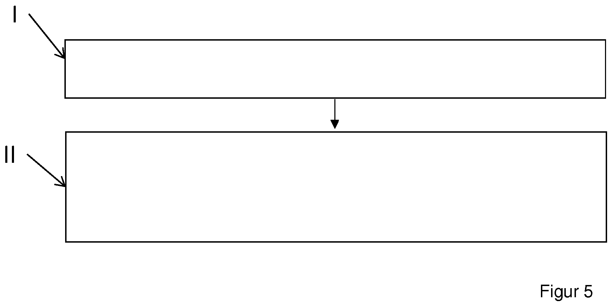

Figur 5 zeigt ein Flussdiagramm eines Ausführungsbeispiels des erfindungsgemäßen Verfahrens zur Herstellung einer erfindungsgemäßen Fensterscheibe 100 mit kapazitivem Schaltbereich 10. Das erfindungsgemäße Verfahren umfasst die folgenden Schritte:
I. Aufbringen einer Low-E-Beschichtung 6 auf eine innenseitige Oberfläche (IV) einer Scheibe 1 und
II. Einbringen mindestens einer Trennlinie 7, die die Low-E-Beschichtung 6 in mindestens einen kapazitiven Schaltbereich 10 und mindestens einen Umgebungsbereich 15 elektrisch unterteilt, bevorzugt durch Laserstrukturierung oder durch mechanisches oder chemisches Abtragen.

Besonders vorteilhaft und überraschend ist eine Scheibenanordnung 200 mit einer Fensterscheibe 100 bzw. eine Scheibenanordnung 201 mit einer Verbundscheibe 101, bei der die Empfindlichkeit der Sensorelektronik 14 derart abgestimmt ist, dass eine berührungslose Auslösung des Schaltvorgangs von einer innenseitigen Oberfläche IV der Fensterscheibe 100 bzw. der Verbundscheibe 101 möglich ist.

Dieses Ergebnis war für den Fachmann unerwartet und überraschend.

### Bezugszeichenliste:

- 1: Scheibe, Innenscheibe
- 5: Teilbereich
- 6: Low-E-Beschichtung
- 7: Trennlinie
- 10: kapazitiver Schaltbereich
- 11: Erfassungsbereich
- 12: Zuleitungsbereich
- 13: Anschlussbereich
- 14: kapazitive Sensorelektronik
- 15: Umgebungsbereich
- 17: Folienleiter
- 21: Leuchtdiode (LED)
- 100: Fensterscheibe
- 101: Verbundscheibe
- 200, 201: Scheibenanordnung
- d₁,: Dicke
- A-A': Schnittlinie
- III: außenseitige Oberfläche der Scheibe 1 oder der Innenscheibe 1
- IV: innenseitige Oberfläche der Scheibe 1 oder der Innenscheibe 1

## Patentansprüche

1. Fensterscheibe (100) mit mehreren kapazitiven Schaltbereichen (10), zur Abtrennung eines Innenraums von einer äußeren Umgebung, umfassend:
- eine Scheibe (1) mit einer innenseitigen Oberfläche (IV) und
- eine Beschichtung (6), die zumindest teilweise auf der innenseitigen Oberfläche (IV) der Scheibe (1) angeordnet ist,
wobei
jeweils ein kapazitiver Schaltbereich (10) durch mindestens eine beschichtungsfreie Trennlinie (7) aus der Beschichtung (6) elektrisch abgetrennt ist, und mit einer Sensorelektronik (14) elektrisch verbindbar ist, sowie einen Erfassungsbereich (11) zum berührungslosen Erfassen von einem von einer Person in einem Aktivierungsbereich bewegten Gegenstand und dessen Bewegungsrichtung aufweist,
wobei
der Erfassungsbereich (11) in zumindest zwei streifenförmige Teilbereiche (5) ausgebildet ist,
die Teilbereiche in einem der Breite der Trennungslinie (7) entsprechenden und beschichtungsfreien Abstand angeordnet sind,
eine Längsachse der Teilbereiche (5) parallel zu einer Seite der innenseitigen Oberfläche verläuft,
ein Teilbereich (5) eine Länge aufweist, die einer Seitenlänge der innenseitigen Oberfläche (IV) entspricht,
die Teilbereiche (5) parallel zueinander angeordnet sind.

2. Fensterscheibe (100) nach Anspruch 1, **dadurch gekennzeichnet, dass** der kapazitive Schaltbereich (10) zur Erzeugung eines elektrischen Feldes, das sich innerhalb des Aktivierungsbereichs erstreckt, vorgesehen ist.

3. Fensterscheibe (100) nach Anspruch 1, **dadurch gekennzeichnet, dass** der Erfassungsbereich (11) eine Fläche aufweist, die der innenseitigen Oberfläche (IV) im Wesentlichen entspricht.

4. Fensterscheibe (100) nach Anspruch 1 oder Anspruch 2, **dadurch gekennzeichnet, dass** der Aktivierungsbereich eine parallelle Fläche zu und von der Größe der innenseitigen Oberfläche (IV) und eine Breite von 10 cm in Richtung des Innenraums aufweist.

5. Fensterscheibe (100) nach Anspruch 1, **dadurch gekennzeichnet, dass** der kapazitive Schaltbereich einen Zuleitungsbereich (12), einen Anschlussbereich (13) und einen Umgebungsbereich (15) aufweist, wobei der Zuleitungsbereich (12) als elektrische Verbindung zwischen dem Erfassungsbereich (11) und dem Anschlussbereich (13) vorgesehen ist und der Anschlussbereich (13) mit einer Sensorelektronik (14) elektrisch verbindbar ist.

6. Fensterscheibe (100) nach einem der Ansprüche 1 bis 5, **dadurch gekennzeichnet, dass** der kapazitive Schaltbereich (10) zur Generierung eines elektrischen Signals vorgesehen ist und/oder der Erfassungsbereich eine Lichtquelle umfasst.

7. Scheibenanordnung (101) umfassend:
- eine Fensterscheibe (100) nach einem der Ansprüche 1 bis 6 und
- eine kapazitive Sensorelektronik (14), die mit dem Erfassungsbereich (11) elektrisch verbunden ist,
wobei die Empfindlichkeit der Sensorelektronik (14) so gewählt ist, dass sie bei einer Erfassung eines von einer Person in einem Aktivierungsbereich bewegten Gegenstands ein Schaltsignal ausgibt.

8. Verbundscheibe (101), mindestens umfassend
- eine Innenscheibe (1), die aus einer Scheibe (1) gemäß einem der Ansprüche 1 bis 6 besteht,
- eine Außenscheibe (2) mit einer innenseitigen Oberfläche (II) und
- mindestens einer Zwischenschicht (2), die die innenseitige Oberfläche (II) der Außenscheibe (2) flächig mit einer außenseitigen Oberfläche (III) der Innenscheibe (1) verbindet und der kapazitive Schalbereich (10) zur elektrischen Steuerung der optischen Transparenz der Zwischenschicht oder einer elektrochromen Zwischenschicht vorgesehen ist.

9. Verfahren zur Herstellung einer Fensterscheibe (100) nach einem der Ansprüche 1 bis 6, mindestens umfassend:
(a) Aufbringen einer Beschichtung (6) auf eine innenseitige Oberfläche (IV) einer Scheibe (1),
(b) Einbringen mindestens einer Trennlinie (7), die die Beschichtung (6) in mehrere kapazitive Schaltbereiche (10) und/oder mindestens einen Umgebungsbereich (15) elektrisch unterteilt, bevorzugt durch Laserstrukturierung oder durch mechanisches oder chemisches Abtragen.

10. Verwendung der Fensterscheibe (100) nach einen der Ansprüche 1 bis 6 oder der Verbundscheibe (110) nach Anspruch 8 in Fortbewegungsmitteln für den Verkehr auf dem Lande, in der Luft oder zu Wasser, insbesondere in Kraftfahrzeugen beispielsweise als Windschutzscheibe, Heckscheibe, Seitenscheiben und/oder Dachscheibe sowie als funktionales Einzelstück, und als Einbauteil in Möbeln, Geräten und Gebäuden, insbesondere als elektrischer Heizkörper.

## Claims

1. Window pane (100) having a plurality of capacitive switching regions (10), for separating an interior from an external environment, comprising:
- a pane (1) having an inner surface (IV) and
- a coating (6) that is arranged at least partially on the inner surface (IV) of the pane (1),
wherein
a respective capacitive switching region (10) is electrically separated from the coating (6) by at least one coating-free dividing line (7) and can be electrically connected to a sensor electronics system (14) and has a detection region (11) for contactlessly detecting an object moved by a person in an activation region and the direction of movement thereof,
wherein
the detection region (11) is implemented in at least two strip-shaped subregions (5), the subregions are arranged at a coating-free distance corresponding to the width of the dividing line (7),
a longitudinal axis of the subregions (5) runs parallel to one side of the inner surface,
a subregion (5) has a length that corresponds to a side length of the inner surface (IV). the subregions (5) are arranged parallel to one another.

2. Window pane (100) according to claim 1, **characterized in that** the capacitive switching region (10) is provided for generating an electric field that extends within the activation region.

3. Window pane (100) according to claim 1, **characterized in that** the detection region (11) has a region that corresponds substantially to the inner surface (IV).

4. Window pane (100) according to claim 1 or claim 2, **characterized in that** the activation region has an region parallel to and of the size of the inner surface (IV) and a width of 10 cm in the direction of the interior.

5. Window pane (100) according to claim 1, **characterized in that** the capacitive switching region has a supply line region (12), a connection region (13), and a surrounding region (15), wherein the supply line region (12) is provided as an electrical connection between the detection region (11) and the connection region (13) and the connection region (13) can be electrically connected to a sensor electronics system (14).

6. Window pane (100) according to one of claims 1 through 5, **characterized in that** the capacitive switching region (10) is provided for generating an electrical signal and/or the detection region includes a light source.

7. Pane arrangement (101) comprising:
- a window pane (100) according to one of claims 1 through 6 and
- a capacitive sensor electronics system (14) that is electrically connected to the detection region (11),
wherein the sensitivity of the sensor electronics system (14) is selected such that it outputs a switching signal upon detection of an object moved by a person in an activation region.

8. Composite pane (101), at least comprising
- an inner pane (1) that consists of a pane (1) according to one of claims 1 to 6,
- an outer pane (2) having an inner surface (II), and
- at least one intermediate layer (2) that joins the inner surface (II) of the outer pane (2) areally to an outer surface (III) of the inner pane (1) and the capacitive switching region (10) is provided for electrically controlling the optical transparency of the intermediate layer or of an electrochromic intermediate layer.

9. Method for producing a window pane (100) according to one of claims 1 through 6, at least comprising:
(a) Applying a coating (6) on an inner surface (IV) of a pane (1),
(b) Introducing at least one dividing line (7) that electrically divides the coating (6) into a plurality of capacitive switching regions (10) and/or at least one surrounding region (15), preferably by laser patterning or by mechanical or chemical ablation.

10. Use of the window pane (100) according to one of claims 1 through 6 or the composite pane (110) according to claim 8 in means of transportation for travel on land, in the air, or on water, in particular in motor vehicles, for example, as a windshield, rear window, side windows, and/or roof panel as well as a functional individual piece, and as a built-in component in furniture, appliances, and buildings, in particular as an electric heater.

## Revendications

1. Vitre de fenêtre (100) ayant une pluralité de régions de commutation capacitives (10), pour séparer un intérieur d'un environnement extérieur, comprenant :
- une vitre (1) ayant une surface intérieure (IV) et
- un revêtement (6) qui est disposé au moins partiellement sur la surface intérieure (IV) de la vitre (1),
dans lequel
une région de commutation capacitive (10) respective est séparée électriquement du revêtement (6) par au moins une ligne de séparation sans revêtement (7) et peut être reliée électriquement à une électronique de détection (14) et présente une région de détection (11) pour la détection sans contact d'un objet déplacé par une personne dans une région d'activation et la direction de son mouvement,
dans lequel
la région de détection (11) est réalisée dans au moins deux sous-régions (5) en forme de bande,
les sous-régions sont disposées à une distance sans revêtement correspondant à la largeur de la ligne de séparation (7),
un axe longitudinal des sous-régions (5) est parallèle à un côté de la surface intérieure,
une sous-région (5) a une longueur qui correspond à une longueur latérale de la surface intérieure (IV).
les sous-régions (5) sont disposées parallèlement les unes aux autres.

2. Vitre (100) selon la revendication 1, **caractérisée en ce que** la région de commutation capacitive (10) est prévue pour générer un champ électrique qui s'étend à l'intérieur de la région d'activation.

3. Vitre (100) selon la revendication 1, **caractérisée en ce que** la région de détection (11) présente une région qui correspond sensiblement à la surface intérieure (IV).

4. Vitre (100) selon la revendication 1 ou la revendication 2, **caractérisée en ce que** la région d'activation a une région parallèle à la surface intérieure (IV) et de la taille de celle-ci et une largeur de 10 cm en direction de l'intérieur.

5. Vitre (100) selon la revendication 1, **caractérisée en ce que** la région de commutation capacitive présente une région de ligne d'alimentation (12), une région de connexion (13) et une région d'entourage (15), la région de ligne d'alimentation (12) étant prévue comme liaison électrique entre la région de détection (11) et la région de connexion (13) et la région de connexion (13) pouvant être reliée électriquement à une électronique de détection (14).

6. Vitre (100) selon l'une des revendications 1 à 5, **caractérisée en ce que** la région de commutation capacitive (10) est prévue pour générer un signal électrique et/ou la région de détection comprend une source lumineuse.

7. Agencement de vitre (101) comprenant :
- une vitre (100) selon l'une des revendications 1 à 6 et
- une électronique de détection capacitif (14) qui est connecté électriquement à la région de détection (11),
dans lequel la sensibilité de la électronique de détection (14) est sélectionnée de telle sorte qu'il émet un signal de commutation lors de la détection d'un objet déplacé par une personne dans une région d'activation.

8. Vitre composite (101), comprenant au moins
- une vitre intérieure (1) qui consiste en une vitre (1) selon l'une des revendications 1 à 6,
- une vitre extérieure (2) ayant une surface intérieure (II), et
- au moins une couche intermédiaire (2) qui relie la surface intérieure (II) de la vitre extérieure (2) à une surface extérieure (III) de la vitre intérieure (1) et la région de commutation capacitive (10) est prévue pour commander électriquement la transparence optique de la couche intermédiaire ou d'une couche intermédiaire électrochrome.

9. Procédé de fabrication d'une vitre (100) selon l'une des revendications 1 à 6, comprenant au moins :
(a) l'application d'un revêtement (6) sur une surface intérieure (IV) d'une vitre (1),
(b) l'introduction d'au moins une ligne de séparation (7) qui divise électriquement le revêtement (6) en une pluralité de régions de commutation capacitives (10) et/ou au moins une région périphérique (15), de préférence par structuration au laser ou par ablation mécanique ou chimique.

10. Utilisation de la vitre (100) selon l'une des revendications 1 à 6 ou de la vitre composite (110) selon la revendication 8 dans des moyens de transport pour des déplacements sur terre, dans les airs ou sur l'eau, en particulier dans des véhicules automobiles, par exemple comme pare-brise, lunette arrière, vitres latérales et/ou panneau de toit ainsi que comme pièce individuelle fonctionnelle, et comme composant intégré dans des meubles, des appareils et des bâtiments, en particulier comme chauffage électrique.
